# FASCICULE DE BREVET EUROPEEN

(11) **EP 4 062 259 B1**
(45) Date de publication et mention de la délivrance du brevet: **01.11.2023**
(21) Numéro de dépôt: 20820497.4
(22) Date de dépôt: 20.11.2020
(51) Int. Cl.: G06F 1/20, H01L 23/367, H01L 23/40

(54) **CALCULATEUR EMBARQUÉ AVEC INTERPOSEUR SUR LA PUCE MICROPROCESSEUR**
BORDCOMPUTER MIT INTERPOSER AUF DEM MIKROPROZESSORCHIP
ON-BOARD COMPUTER WITH INTERPOSER ON THE MICROPROCESSOR CHIP

(30) Priorité: 21.11.2019 FR 1913042
(43) Date de publication de la demande: 28.09.2022
(73) Titulaire: Safran Electronics & Defense, 75015 Paris (FR)
(72) Inventeur: POILVET, Christophe, 77550 MOISSY-CRAMAYEL (FR); CHARRIER, Nicolas, 77550 MOISSY-CRAMAYEL (FR); MONTOYA, Michael, 77550 MOISSY-CRAMAYEL (FR)
(74) Mandataire: Regimbeau
(86) Numéro de dépôt international: PCT/FR2020/052142
(87) Numéro de publication internationale: WO 2021/099750

(56) Documents cités:
- DE-U1-202009 000 460
- US-A1- 2005 068 739
- US-A1- 2008 116 570
- US-A1- 2013 105 964

## Description

### Domaine technique

La présente invention se rapporte au domaine des équipements électriques embarqués et plus précisément à un calculateur embarqué comprenant une puce microprocesseur, un support de puce, et un boîtier évacuant la chaleur dégagée par la puce lors de son fonctionnement, le calculateur étant embarqué dans un véhicule, aérien comme un aéronef ou terrestre comme un engin muni de roues ou de chenilles.

Un calculateur embarqué doit pouvoir assurer le fonctionnement qui lui est dévolu tout en faisant face à un certain nombre de contraintes. Un calculateur embarqué doit en particulier :
- offrir une disponibilité élevée quelque soient les conditions de l'environnement du véhicule,
- présenter un faible encombrement,
- être robuste aux effets induits par le fonctionnement du véhicule (vibrations, températures élevées),
- prendre place dans un environnement confiné.

Ces contraintes induisent des problèmes pour différents aspects liés au fonctionnement d'un calculateur. En particulier, toute puce microprocesseur dégage lors de son fonctionnement de la chaleur, pouvant atteindre plus de 100°C. Or, les contraintes auxquelles doivent faire face un calculateur embarqué peuvent rendre difficile l'évacuation de cette chaleur.

En effet, il n'est souvent pas possible, à la fois pour des raisons de fiabilité et de confinement, d'utiliser un apport de fluide refroidisseur, comme par exemple un flux d'air extérieur, le boîtier du calculateur étant généralement étanche. En outre, un dispositif de circulation de fluide, typiquement un ventilateur ou une pompe, est sujet à des pannes qui ne peuvent être acceptées pour un calculateur embarqué dont la fiabilité est critique pour le véhicule.

Un calculateur embarqué est donc généralement refroidi par diffusion thermique de contact qui consiste à transmettre la chaleur dégagée par la puce microprocesseur au boîtier du calculateur. Un radiateur est donc posé en contact avec la puce microprocesseur pour en drainer la chaleur. Ce type de refroidissement nécessite toutefois un contact entre le radiateur et la puce microprocesseur qui s'étende de manière uniforme sur toute la surface de la puce microprocesseur. Cependant, comme tout système mécanique, des jeux sont prévus entre les différents composants (puce microprocesseur, support de puce, radiateur, boîtier, etc.) afin de permettre l'adaptation aux tolérances de dimensions et de permettre le montage du calculateur.

Des éléments élastiques tels que des ressorts ou du gel peuvent être prévus pour rattraper les différents jeux entre les composants, et assurer le maintien mécanique des composants. Du fait que le calculateur est embarqué, le calculateur est toutefois soumis à de fortes vibrations induites par le fonctionnement du véhicule. En raison de ces vibrations et de l'élasticité des éléments élastiques, les composants du calculateur peuvent subir des déplacements relatifs qui mettent en péril le refroidissement de la puce microprocesseur.

Une autre solution est de prévoir des tolérances de fabrication très faibles, avec un respect strict de dimensions très précises. Une telle exigence augmente toutefois considérablement les coûts de fabrication, complexifie le montage, et peut poser des problèmes face à la dilatation thermique. Par ailleurs, afin de compenser les inévitables tolérances de dimensions, le matelas thermique disposé entre la puce microprocesseur et le boîtier doit être épaisse, ce qui réduit l'efficacité de l'évacuation de la chaleur vers le boîtier.

La demande de brevet US2013/0105964 décrit un dispositif semi-conducteur dans lequel une plaque de radiateur est disposée entre un élément semi-conducteur et un puit thermique, la plaque de radiateur formant un diffuseur de chaleur. Toutefois, le montage d'une telle plaque de radiateur au contact de l'élément semi-conducteur est complexe et des imperfections subsistantes nuisent à l'efficacité du refroidissement.

Les demandes de brevet DE202009000460U et US2013105964 montrent des dispositifs similaires. En outre, la demande US2008116570 divulgue deux rebords de calage en contact avec les parois d'un support de puce pour positionner un radiateur sur ladite puce.

### Présentation de l'invention

L'invention vise à permettre à un calculateur embarqué de refroidir efficacement sa puce microprocesseur d'une façon robuste aux vibrations, sans élément mobile, et sans nécessiter de fabrication ou de montage complexe et coûteux.

A cet effet, l'invention propose un calculateur embarqué selon la revendication 1.

L'invention est avantageusement complétée par les différentes caractéristiques suivantes prises seules ou selon leurs différentes combinaisons possibles :
- l'interposeur présente une surface supérieure d'échange thermique avec le boîtier du calculateur qui est au moins quatre fois supérieure à la superficie de la face supérieure de la puce microprocesseur ;
- l'interposeur est métallique ;
- un rebord périphérique de calage ne s'étend pas sur tout le côté de l'interposeur où il est situé ;
- une pâte thermique est disposée entre la puce microprocesseur et l'interposeur ;
- un matelas thermique est disposée entre l'interposeur et le boîtier du calculateur ;
- une matière adhésive maintient au moins une partie d'une périphérie de l'interposeur avec la face supérieure du support de puce ;
- l'interposeur présente une face supérieure plane, et une face inférieure dont la périphérie présente une surépaisseur et dont le centre définit une cavité accueillant la face supérieure de la puce microprocesseur ;
- un rebord périphérique de calage prolonge l'interposeur radialement par rapport au centre au-delà de la périphérie, de sorte que le rebord périphérique de calage dépasse de la face supérieure du support de puce ;
- le centre de l'interposeur présente une épaisseur comprise entre 1 mm et 2 mm, et la périphérie de l'interposeur présente une épaisseur comprise entre 2 mm et 4 mm.

### Présentation des figures

D'autres caractéristiques, buts et avantages de l'invention ressortiront de la description qui suit, qui est purement illustrative et non limitative, et qui doit être lue en regard des dessins annexés sur lesquels :
- la figure 1 est une vue de de dessus montrant le support de puce, l'interposeur, et la puce microprocesseur, selon un mode de réalisation possible de l'invention ;
- la figure 2 est une vue selon la coupe BB de la figure 1 ;
- la figure 3 est une vue selon la coupe AA de la figure 1, avec en plus le matelas thermique et le boîtier ;
- la figure 4 est une vue en perspective de l'interposeur selon un mode de réalisation possible de l'invention.

### Description détaillée

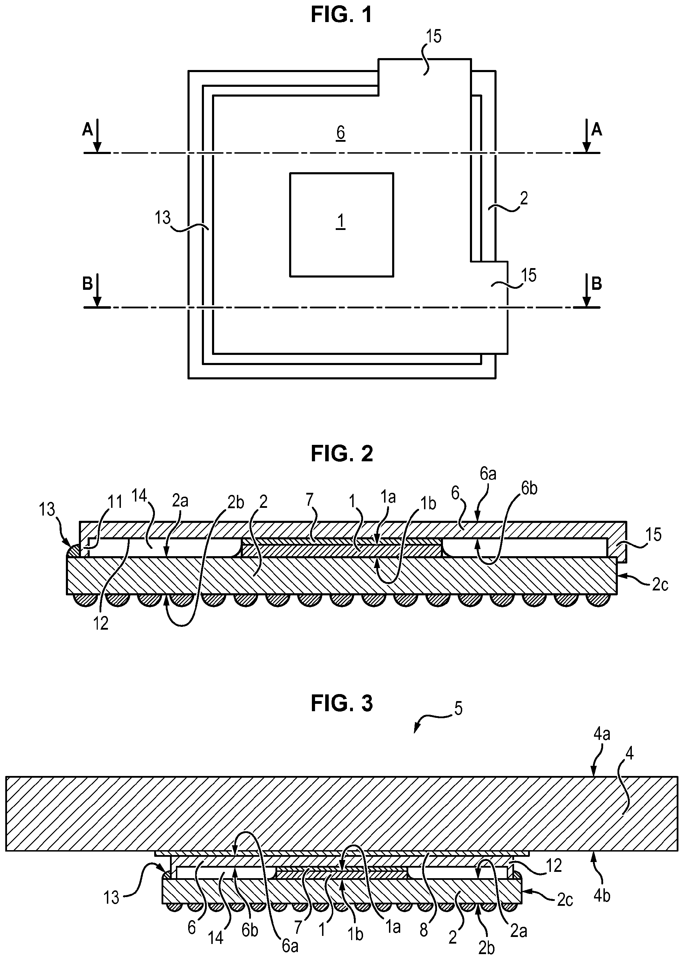

En référence aux figures 1 à 3, le calculateur embarqué comprend une puce microprocesseur 1 avec une face inférieure 1a et une face supérieure 1b. Une puce microprocesseur est un circuit intégré qui incorpore les fonctions d'une unité centrale de traitement informatique, et qui qui exécute des instructions et traite des données. La puce microprocesseur 1 peut être de tout type, et peut par exemple être dédiée aux fonctions de communication ou de traitement du signal.

La puce microprocesseur 1 est montée sur un support de puce 2, et plus précisément sur la face supérieure 2a du support de puce 2. Dans l'exemple illustré, la puce microprocesseur 1 est de type puce retournée (plus connue sous le terme anglais équivalent "flip chip"), et le face inférieure 2b du support de puce 2 est pourvue de billes de soudure 3 permettant la connexion de la puce microprocesseur 1 avec d'autres composants électroniques (autre calculateur, capteurs, actionneurs, etc.) ainsi que son alimentation électrique.

Le calculateur embarqué comprend également un boîtier 4, visible sur la figure 3, qui est configuré pour évacuer la chaleur dégagée par la puce microprocesseur en fonctionnement en direction de l'environnement 5 extérieur au calculateur, via la face supérieure 4a du boîtier. Le boîtier 4 peut présenter des ailettes ou autre dispositif permettant d'augmenter la surface d'échange pour maximiser les transferts de chaleur entre le boîtier 4 et l'environnement 5 extérieur. L'environnement 5 extérieur est de préférence de l'air, mais peut être tout type d'environnement permettant d'évacuer la chaleur. Le boîtier 4 est typiquement constitué de métal, dont la bonne conduction thermique lui permet d'assurer son rôle de puit thermique.

Entre la face supérieure 1a de la puce microprocesseur 1 et la face inférieure 4b du boîtier 4, un interposeur 6 est disposé. L'interposeur est configuré pour diffuser la chaleur transmise par la face supérieure 1a de la puce microprocesseur vers le boîtier 4. A ce titre, l'interposeur 6 peut également être désigné comme un diffuseur de chaleur. De préférence, comme illustré sur la figure 1, la puce microprocesseur 1 est sensiblement centrée sur le support de puce 2, et l'interposeur 6 est sensiblement centré sur le support de puce 2, de sorte que la puce microprocesseur 1 est sensiblement au centre de l'interposeur 6, ce qui favorise une évacuation homogène de la chaleur. Il est à noter que sur la figure 1 fait apparaître la puce microprocesseur 1 à des fins d'illustration, celle-ci étant normalement masqué par l'interposeur 6 reposant dessus. Comme illustré, l'interposeur 6 partage de préférence la même forme que le support de puce 2, et sensiblement la même taille. Typiquement, le support de puce 2 et le l'interposeur 6 ont des formes de quadrilatères (carrés ou rectangles).

Une pâte thermique 7 est disposée entre la face supérieure 1a de la puce microprocesseur 1 et l'interposeur 6. La pâte thermique 7 peut comprendre des charges métalliques, et est par exemple une pâte de polymère ou céramique chargée en métal, typiquement de l'argent, du cuivre ou des composés d'aluminium. D'autres compositions peuvent être utilisées. La pâte thermique 7 permet de remplir les micro porosités due à la rugosité de la face supérieure 1a de la puce microprocesseur 1 et de la face inférieure 6b de l'interposeur 6, avec une substance dont la conductivité thermique est beaucoup plus élevée que celle de l'air, améliorant ainsi le transfert thermique. Toutefois, contrairement à l'état de la technique, la pâte thermique 7 n'a pas ici pour rôle de corriger les défauts de planéité de la face supérieure 1a de la puce microprocesseur 1 ou de la surface inférieure 4b du boîtier 4 engendrés par les tolérances de fabrication. La pâte thermique 7 peut ainsi être présente sur une très faible épaisseur, typiquement inférieure à 1 mm, voire inférieure à 0,5 mm ou même à 0,3 mm.

Entre l'interposeur 6 et le boîtier 4, et plus précisément entre la face supérieure 6a de l'interposeur 6 et la face inférieure 4b du boîtier 4, un matelas thermique 8 est disposé. Le matelas thermique 8 est par exemple une pâte non conductrice pour éviter les courts-circuits . D'autres compositions peuvent être utilisées. Comme la pâte thermique 7, le matelas thermique 8 sert de joint thermique, ici entre l'interposeur 6 et le boîtier 4 afin de faciliter les transferts thermiques depuis l'interposeur 6 vers le boîtier 4. Le matelas thermique 8 peut en revanche être utilisé pour rattraper les légers défauts de planéités qui pourraient exister sur la face supérieure 6a de l'interposeur 6 et la face inférieure 4b du boîtier 4. A ce titre, le matelas thermique 8 peut être plus épais que la pâte thermique 7. Il est à noter que le matelas thermique 8 a une épaisseur plus importante que la pâte thermique 7.

La chaleur dégagée par la puce microprocesseur 1 lors de son fonctionnement est transférée à l'interposeur 6 qui transfert cette chaleur au boîtier 4. Afin d'améliorer l'évacuation de la chaleur, l'interposeur 6 présentant une surface supérieure d'échange thermique avec le boîtier 4 qui est au moins deux fois supérieure à la superficie de la face supérieure 1a de la puce microprocesseur 1, et de préférence au moins quatre fois supérieure à la superficie de la face supérieure 1a de la puce microprocesseur 1. Cette surface supérieure d'échange thermique est constituée par la face supérieure 6a de l'interposeur. La plus grande surface supérieure d'échange thermique permet d'évacuer efficacement la chaleur depuis l'interposeur 6 vers le boîtier 4, refroidissant ainsi l'interposeur 6 et améliorant donc le refroidissement de la puce microprocesseur 1. Cela est d'autant plus avantageux que le matelas thermique 8 forme un joint thermique moins efficace que la couche de pâte thermique 7, c'est-à-dire avec une moindre conductivité thermique, notamment en raison de son épaisseur plus importante. L'augmentation de la surface d'échange thermique avec le boîtier 4, ainsi que la réduction de l'épaisseur de la pâte thermique 7, permises par l'interposeur 6, améliore sensiblement les transferts thermiques entre la puce microprocesseur 1 et le boîtier 4.

De fait, en raison de la miniaturisation croissante des puces microprocesseurs, la face supérieure 1a d'une puce microprocesseur 1 est généralement d'une superficie très restreinte, et les échanges thermiques avec le boîtier 4 sont alors restreints à cette faible superficie, ce qui entrave le refroidissement de la puce microprocesseur 1. L'interposeur 6 permet d'augmenter de plusieurs fois la surface d'échange thermique avec le boîtier 4. Par exemple, alors qu'une puce microprocesseur 1 présente une face supérieure 1a de 5 x 5 mm de côté, l'interposeur 6 peut par exemple présenter une face supérieure 6a, en contact avec le boîtier 4 via le matelas thermique 8, de 20 x 20 mm de côté, soit une augmentation d'un facteur 16.

L'interposeur 6 est de préférence constitué d'une seule pièce. L'interposeur 6 est constitué d'un matériau présentant une bonne conduction thermique, et est typiquement en métal. Plus particulièrement, l'interposeur 6 peut être fait en cuivre ou en aluminium, qui combinent une bonne conduction thermique et une bonne rigidité permettant de faire un interposeur mince et rigide.

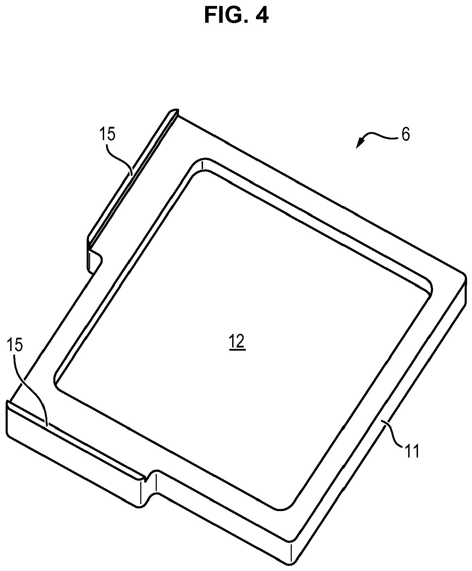

La figure 4 montre un exemple d'un interposeur 6 selon un mode de réalisation avantageux et non limitatif de l'invention. Sur la figure 4 est visible le côté inférieur de l'interposeur 6, c'est-à-dire le côté de la puce microprocesseur 1 et du support de puce 2. Sur le côté opposé, non représenté sur la figure 4, l'interposeur 6 présente une face supérieure 6a de préférence plane et lisse afin de maximiser la surface d'échange thermique avec le boîtier 4.

Du côté visible sur la figure 4, l'interposeur 6 a une face inférieure 6b qui n'est de préférence pas plane. La face inférieure 6b peut avoir une périphérie 11 présentant une surépaisseur et un centre 12 définissant une cavité accueillant la face supérieure 1a de la puce microprocesseur 1. En largeur, la périphérie 11 représente moins de 20% du demi-diamètre de la face inférieure 6b de l'interposeur 6. La périphérie 11 est de préférence surépaissie sur la majorité de la périphérie de l'interposeur 6, et la partie surépaissie est de préférence fermée, formant ainsi un cadre rigidifiant l'interposeur 6, ce qui permet de prévoir un centre 12 de faible épaisseur tout en conservant la rigidité nécessaire à assurer la planéité de la face supérieure 6a de l'interposeur 6 nécessaire à un bon contact avec le boîtier 4 via le matelas thermique 8. La faible épaisseur du centre 12 permet d'améliorer la conductivité thermique entre la puce microprocesseur 1 et le boîtier 4. Typiquement, le centre 12 présente une épaisseur inférieure à la moitié de la surépaisseur de la périphérie 11. A titre d'exemple, le centre 12 de l'interposeur 6 peut présenter une épaisseur comprise entre 1 mm et 2 mm, et la périphérie 11 de l'interposeur 6 peut présenter une épaisseur comprise entre 2 mm et 4 mm.

La périphérie 11 surépaissie forme donc une saillie en direction du support de puce 2, mais de préférence ne sert pas à supporter l'interposeur 6. De fait, la surépaisseur de la périphérie 11 par rapport au centre 12 ne dépasse pas l'élévation de la puce microprocesseur 1 au-dessus du support de puce 2. L'interposeur 6 est supporté par la face supérieure 1a de la puce microprocesseur 1 : l'interposeur 6 repose sur la face supérieure 1a de la puce microprocesseur 1 (par l'intermédiaire de la couche de pâte thermique 7) par son centre 12, et non sur le support de puce 2 par sa périphérie 11.

La périphérie 11 surépaissie s'étend toutefois de préférence très proche du support de puce 2. Une matière adhésive 13 maintient au moins une partie de la périphérie 11 de l'interposeur 6 avec la face supérieure 2a du support de puce 2. La matière adhésive 13 est typiquement un cordon de colle. Autour de la puce microprocesseur 1, le centre 12 de la face inférieure 6b de l'interposeur 6 fait face à la face supérieure 2a du support de puce 2 et en est espacé, définissant ainsi un espace libre 14 autour de la puce microprocesseur 1. Cet espace libre 14 est rempli d'air, et permet un allègement de l'ensemble formé par le support de puce 2, la puce microprocesseur 1 et l'interposeur 6. En outre, la présence d'air autour de la puce microprocesseur 1 permet à la pâte de couler et d'alléger le poids de l'ensemble.

L'interposeur 6 comprend deux rebords périphériques de calage 15 venant au contact d'une paroi latérale 2c du support de puce 2, comme illustré sur la figure 2. Cette paroi latérale 2c du support de puce 2 relie la face supérieure 2a et la face inférieure 2b du support de puce 2. Le rebord périphérique de calage 15 prolonge l'interposeur 6 radialement par rapport au centre 12 au-delà de la périphérie 11, de sorte que le rebord périphérique de calage 15 dépasse de la face supérieure 2a du support de puce 2, comme montré sur la figure 1. Le rebord périphérique de calage 15 s'étend du côté opposé à la face supérieure 6a de l'interposeur 6 sur une distance par rapport au centre 12 de l'interposeur 6 supérieure à celle de l'élévation de la puce microprocesseur 1 sur le support de puce 2, et vient ainsi contre la paroi latérale 2c du support de puce 2.

Le rebord périphérique de calage 15 sert de référence de positionnement lors de la mise en place de l'interposeur 6 sur la puce microprocesseur 1 : il suffit de faire glisser l'interposeur 6 sur la face supérieure 1a de la puce microprocesseur 1 jusqu'à ce que le rebord périphérique de calage 15 vienne au contact de la paroi latérale 2c du support de puce 2. Le rebord périphérique de calage 15 permet donc d'assurer facilement le positionnement de l'interposeur 6 dans la direction perpendiculaire à son contact avec la paroi latérale 2c du support de puce 2. Selon l'invention, afin de permettre le calage dans les deux directions perpendiculaires à deux faces latérales adjacentes du support de puce 2, l'interposeur 6 présente deux rebords périphériques de calage 15 venant chacun au contact d'une paroi latérale 2c respective du support de puce 2, comme illustré sur la figure 4. L'interposeur 6 présente pas plus de deux rebords périphériques de calage 15, afin de laisser les autres côtés de l'interposeur 6 libres afin de faciliter le montage et de ne pas ajouter de contraintes de dimensionnement supplémentaires.

De préférence, un rebord périphérique de calage 15 ne s'étend pas sur tout le côté de l'interposeur 6 où il est situé, de préférence encore sur moins de la moitié de ce côté.

L'invention n'est pas limitée au mode de réalisation décrit et représenté aux figures annexées. Des modifications restent possibles, notamment du point de vue de la constitution des divers caractéristiques techniques sans sortir pour autant du domaine de protection de l'invention.

## Revendications

1. Calculateur embarqué comprenant une puce microprocesseur (1) avec une face inférieure (1b) et une face supérieure (1a), un support de puce (2) présentant au moins deux parois latérales adjacentes et une face supérieure (2a) sur laquelle est montée la puce microprocesseur (1), et un boîtier (4) configuré pour évacuer la chaleur dégagée par la puce microprocesseur (1) en fonctionnement,
dans lequel un interposeur (6) est disposé entre la face supérieure (1a) de la puce microprocesseur (1) et le boîtier (4) du calculateur, l'interposeur étant supporté par la face supérieure de la puce microprocesseur (1) et étant configuré pour diffuser la chaleur transmise par la face supérieure (1a) de la puce microprocesseur (1) vers le boîtier (4) du calculateur, l'interposeur (6) présentant une surface supérieure d'échange thermique avec le boîtier (4) du calculateur qui est au moins deux fois supérieure à la superficie de la face supérieure (1a) de la puce microprocesseur (1), **caractérisé en ce que** l'interposeur (6) présente sur des côtés adjacents deux rebords périphériques de calage (15) venant chacun au contact d'une paroi latérale adjacente (2c) respective du support de puce (2), l'interposeur (6) ne présentant pas plus de deux rebords périphériques de calage (15), afin de laisser les autres côtés de l'interposeur (6) libres.

2. Calculateur embarqué selon la revendication 1, dans lequel l'interposeur (6) présente une surface supérieure d'échange thermique avec le boîtier (4) du calculateur qui est au moins quatre fois supérieure à la superficie de la face supérieure (1a) de la puce microprocesseur (1).

3. Calculateur embarqué selon l'une quelconque des revendications précédentes, dans lequel un rebord périphérique de calage (15) ne s'étend pas sur tout le côté de l'interposeur (6) où il est situé.

4. Calculateur embarqué selon l'une quelconque des revendications précédentes, dans lequel une pâte thermique (7) est disposée entre la puce microprocesseur (1) et l'interposeur (6).

5. Calculateur embarqué selon l'une quelconque des revendications précédentes, dans lequel un matelas thermique (8) est disposée entre l'interposeur (6) et le boîtier (4) du calculateur.

6. Calculateur embarqué selon l'une quelconque des revendications précédentes, dans lequel une matière adhésive (13) maintient au moins une partie d'une périphérie (11) de l'interposeur (6) avec la face supérieure (2a) du support de puce (2).

7. Calculateur embarqué selon l'une quelconque des revendications précédentes, dans lequel l'interposeur (6) présente une face supérieure (6a) plane, et une face inférieure (6b) dont la périphérie (11) présente une surépaisseur et dont le centre (12) définit une cavité accueillant la face supérieure (1a) de la puce microprocesseur (1).

8. Calculateur embarqué selon la revendication précédente, dans lequel un rebord périphérique de calage (15) prolonge l'interposeur (6) radialement par rapport au centre (12) au-delà de la périphérie (11), de sorte que le rebord périphérique de calage (15) dépasse de la face supérieure (2a) du support de puce (2).

9. Calculateur embarqué selon la revendication 7 ou 8, dans lequel le centre (12) de l'interposeur (6) présente une épaisseur comprise entre 1 mm et 2 mm, et la périphérie (11) de l'interposeur (6) présente une épaisseur comprise entre 2 mm et 4 mm.

## Patentansprüche

1. Bordcomputer, einen Mikroprozessorchip (1) mit einer unteren Fläche (1b) und einer oberen Fläche (1a) umfassend, und einen Chipträger (2), der mindestens zwei benachbarte Seitenwände aufweist, und eine obere Fläche (2a), auf der der Mikroprozessorchip (1) montiert ist, und ein Gehäuse (4), das konfiguriert ist, um die Wärme abzuführen, die vom Mikroprozessorchip (1) im Betrieb abgegeben wird,
wobei ein Interposer (6) zwischen der oberen Fläche (1a) des Mikroprozessorchips (1) und dem Gehäuse (4) des Computers angeordnet ist, wobei der Interposer von der oberen Fläche des Mikroprozessorchips (1) getragen wird und konfiguriert ist, um die von der oberen Fläche (1a) des Mikroprozessorchips (1) übertragene Wärme an das Gehäuse (4) des Computers zu verteilen, wobei der Interposer (6) eine obere Oberfläche des Wärmeaustauschs mit dem Gehäuse (4) des Computers aufweist, die mindestens zweimal größer ist als der Flächeninhalt der oberen Fläche (1a) des Mikroprozessorchips (1),
**dadurch gekennzeichnet, dass** der Interposer (6) an benachbarten Seiten zwei periphere Verkeilungskanten (15) aufweist, die jeweils mit einer jeweiligen benachbarten Seitenwand (2c) des Chipträgers (2) in Kontakt kommen, wobei der Interposer (6) nicht mehr als zwei periphere Verkeilungskanten (15) aufweist, um die anderen Seiten des Interposers (6) frei zu lassen.

2. Bordcomputer nach Anspruch 1, wobei der Interposer (6) eine obere Oberfläche des Wärmeaustauschs mit dem Gehäuse (4) des Computers aufweist, die mindestens viermal größer ist als der Flächeninhalt der oberen Fläche (1a) des Mikroprozessorchips (1).

3. Bordcomputer nach einem der vorhergehenden Ansprüche, wobei sich eine periphere Verkeilungskante (15) nicht über die gesamte Seite des Interposers (6) erstreckt, wo sie sich befindet.

4. Bordcomputer nach einem der vorhergehenden Ansprüche, wobei eine Wärmeleitpaste (7) zwischen dem Mikroprozessorchip (1) und dem Interposer (6) angeordnet ist.

5. Bordcomputer nach einem der vorhergehenden Ansprüche, wobei eine Wärmematte (8) zwischen dem Interposer (6) und dem Gehäuse (4) des Computers angeordnet ist.

6. Bordcomputer nach einem der vorhergehenden Ansprüche, wobei ein Klebstoffmaterial (13) mindestens einen Teil einer Peripherie (11) des Interposers (6) mit der oberen Fläche (2a) des Chipträgers (2) zusammenhält.

7. Bordcomputer nach einem der vorhergehenden Ansprüche, wobei der Interposer (6) eine ebene obere Fläche (6a) aufweist und eine untere Fläche (6b), deren Peripherie (11) eine Überdicke aufweist und deren Zentrum (12) einen Hohlraum definiert, der die obere Fläche (1a) des Mikroprozessorchips (1) aufnimmt.

8. Bordcomputer nach dem vorhergehenden Anspruch, wobei eine periphere Verkeilungskante (15) den Interposer (6) radial aufs Zentrum (12) bezogen über die Peripherie (11) hinaus verlängert, so dass die periphere Verkeilungskante (15) über die obere Fläche (2a) des Chipträgers (2) hinausragt.

9. Bordcomputer nach Anspruch 7 oder 8, wobei das Zentrum (12) des Interposers (6) eine Dicke zwischen 1 mm und 2 mm aufweist und die Peripherie (11) des Interposers (6) eine Dicke zwischen 2 mm und 4 mm aufweist.

## Claims

1. On-board computer comprising a microprocessor chip (1) with a bottom face (1b) and a top face (1a), a chip carrier (2) having at least two adjacent side walls and a top face (2a) on which the microprocessor chip (1) is mounted, and a housing (4) configured to dissipate heat generated by the microprocessor chip (1) during operation, wherein an interposer (6) is disposed between the top face (1a) of the microprocessor chip (1) and the computer housing (4), the interposer being supported by the top face of the microprocessor chip (1) and being configured to diffuse heat transmitted by the top face (1a) of the microprocessor chip (1) to the computer housing (4), the interposer (6) having a surface area for heat exchange with the computer housing (4) which is at least twice as large as the surface area of the top face (1a) of the microprocessor chip (1),
**characterized in that** the interposer (6) has, on adjacent sides, two peripheral wedging edges (15), each of which comes into contact with a respective adjacent side wall (2c) of the chip carrier (2 ), the interposer (6) having no more than two peripheral wedging edges (15), so as to leave the other sides of the interposer (6) free.

2. On-board computer according to claim 1, in which the interposer (6) has an upper surface for heat exchange with the computer housing (4) which is at least four times greater than the surface area of the upper face (1a) of the microprocessor chip (1).

3. On-board computer according to any one of the preceding claims, wherein a peripheral wedging rim (15) does not extend over the entire side of the interposer (6) where it is located.

4. On-board computer according to any one of the preceding claims, wherein a thermal paste (7) is arranged between the microprocessor chip (1) and the interposer (6).

5. On-board computer according to any of the preceding claims, wherein a thermal mat (8) is arranged between the interposer (6) and the computer housing (4).

6. On-board computer according to any one of the preceding claims, wherein an adhesive material (13) holds at least part of a periphery (11) of the interposer (6) to the top face (2a) of the chip carrier (2).

7. On-board computer according to any one of the preceding claims, wherein the interposer (6) has a flat upper face (6a), and a lower face (6b) whose periphery (11) has an extra thickness and whose center (12) defines a cavity accommodating the upper face (1a) of the microprocessor chip (1).

8. On-board computer according to the preceding claim, wherein a peripheral wedging rim (15) extends the interposer (6) radially with respect to the center (12) beyond the periphery (11), so that the peripheral wedging rim (15) projects beyond the top face (2a) of the chip carrier (2).

9. On-board computer according to claim 7 or 8, wherein the center (12) of the interposer (6) has a thickness of between 1 mm and 2 mm, and the periphery (11) of the interposer (6) has a thickness of between 2 mm and 4 mm.
